# FASCICULE DE BREVET EUROPEEN

(11) **EP 1 016 220 B1**
(45) Date de publication et mention de la délivrance du brevet: **14.11.2001**
(21) Numéro de dépôt: 98944029.2
(22) Date de dépôt: 21.09.1998
(51) Int. Cl.: H03M 1/34

(54) **CONVERTISSEUR ANALOGIQUE-NUMERIQUE A CIRCUIT DE REPLIEMENT ARBORESCENT**
ANALOG-DIGITALER UMWANDLER MIT BAUMSTRUKTURIERTEN FALTKREISLAUF
ANALOG-DIGITAL CONVERTER WITH TREE-STRUCTURED FOLDING CIRCUIT

(30) Priorité: 19.09.1997 FR 9711699
(43) Date de publication de la demande: 05.07.2000
(73) Titulaire: Atmel Grenoble S.A., 38120 Saint Egreve (FR)
(72) Inventeur: BORE, François, Thomson-CSF Propriété Int., F-94117 Arcueil Cedex (FR); WINGENDER, Marc, Thomson-CSF Propriété Intel., F-94117 Arcueil Cedex (FR)
(74) Mandataire: Guérin, Michel
(86) Numéro de dépôt international: FR9802013
(87) Numéro de publication internationale: WO9916173

(56) Documents cités:
- EP-A- 0 600 788
- WO-A-92/08288
- US-A- 5 376 937
- HIROSHI KIMURA: "A 10-B 300-MHZ INTERPOLATED-PARALLEL A/D CONVERTER" IEEE JOURNAL OF SOLID-STATE CIRCUITS, vol. 28, no. 4, 1 avril 1993, pages 438-446, XP000362972

## Description

L'invention concerne les convertisseurs analogiques-numériques, c'est-à-dire les circuits électroniques capables de convertir un signal d'entrée analogique en une valeur numérique précise représentant l'amplitude du signal analogique. La valeur numérique est obtenue sous forme d'un mot de plusieurs bits, codé en binaire pur ou en un autre code.

Plusieurs procédés de conversion existent, et le choix d'un procédé plutôt qu'un autre dépend des performances que l'on attend du convertisseur. Les paramètres les plus importants de ces performances sont:
- la résolution, définie par le nombre de bits du mot de sortie représentant avec exactitude l'amplitude du signal analogique ; le nombre de bits peut être de 16 à 18, voire 20, pour les convertisseurs les plus précis, et la précision est en général de + ou - 1/2 bit de poids le plus faible;
- la rapidité, c'est-à-dire le nombre d'opérations de conversion qu'on peut effectuer en une seconde;
- la consommation de puissance : un convertisseur rapide et précis consomme beaucoup plus d'énergie qu'un convertisseur lent et peu précis ; or la consommation de puissance entraîne un échauffement de la puce de circuit intégré sur laquelle est réalisé le convertisseur. Cet échauffement doit être compensé par des moyens de refroidissement qui rendent le circuit difficilement utilisable lorsqu'il y a des contraintes d'encombrement à respecter. De plus, avec la multiplication des équipements dits "portables" (fonctionnant à l'aide de piles), le critère "consommation de puissance élevée" devient également synonyme de "faible durée de vie de l'équipement";
- et bien sûr le coût de conception et de fabrication du convertisseur lié en particulier à la surface de puce de circuit intégré utilisée par le convertisseur.

Les qualités d'un convertisseur analogique-numérique résultent d'un compromis entre les paramètres ci-dessus et un but de la présente invention est d'améliorer ce compromis.

Parmi les structures connues de convertisseurs analogiques-numériques, on peut citer :
- les convertisseurs à approximations successives, de fonctionnement relativement lent;
- les convertisseurs "flash" qui utilisent 2^{N} comparateurs en parallèle, de structure encombrante et consommant une puissance élevée;
- les convertisseurs à interpolation, à structure en série (plusieurs étages en cascade) ou en parallèle;
- les convertisseurs à repliement de signal.

L'invention s'intéresse à cette dernière catégorie de convertisseur, qui peut d'ailleurs être associée aux autres catégories dans des convertisseurs mixtes.

Le rôle d'un circuit de repliement de signal est de produire au moins deux tensions dites "repliées" : ce sont des tensions analogiques qui varient sensiblement sinusoïdalement en fonction de la tension Vin à convertir, et qui se croisent pour plusieurs valeurs de Vin qui sont des valeurs de référence parfaitement déterminées, régulièrement réparties dans un intervalle de tension où Vin est susceptible de varier.

Le circuit de repliement de signal peut avoir deux fonctions différentes (et en général il aura les deux) :
- il fournit des informations sur la position de la tension Vin par rapport aux différentes valeurs de référence; ces informations servent à établir les bits de poids fort de la conversion analogique-numérique,
- et, de plus, il fournit à sa sortie des tensions analogiques repliées qui peuvent être utilisées par des circuits d'interpolation série ou parallèle pour fournir des bits de poids plus faible améliorant la résolution de la conversion analogique-numérique.

Un but de la présente invention est de proposer un tel circuit de repliement de signal et de l'incorporer à une architecture de convertisseur analogique-numérique. Le circuit proposé offre un bon compromis entre les paramètres évoqués ci-dessus, et notamment la précision et la consommation de puissance.

On propose donc un convertisseur analogique-numérique qui comporte un circuit de repliement de signal comprenant :
- des moyens pour produire n paires de tensions variant de manière monotone avec Vin, les tensions d'une paire de rang k se croisant lorsque Vin a une valeur de référence égale à Vₖ et variant linéairement autour de leur point de croisement, les tensions Vₖ étant régulièrement distribuées,
- au moins deux circuits d'aiguillage de courant, dont chacun possède au moins trois paires d'entrées et au moins deux sorties appelées sortie directe et sortie inverse,
   un circuit d'aiguillage de rang i ayant les caractéristiques suivantes :
   - il reçoit au moins les paires de tensions de rang k-1, k, et k+1, les circuits de rang différent recevant des ensembles de paires de tensions différents,
   - il comporte une source de courant alimentant un groupe de branches montées en structure arborescente à au moins deux étages dont le dernier comporte au moins quatre branches, chaque branche d'un étage alimentant deux branches de l'étage suivant, la répartition du courant dans chaque embranchement étant fonction des paires de tension de rang k-1, k, et k+1, et les sorties directe et inverse de ce circuit étant prises respectivement sur deux branches différentes du dernier étage,
   les sorties directes des différents circuits d'aiguillage étant reliées entre elles pour additionner les courants qui les parcourent et fournissant un premier signal replié, et les sorties inverses étant également reliées entre elles et fournissant un deuxième signal replié complémentaire du premier.

Des informations sur la position de Vin par rapport aux tensions de référence sont obtenues en combinant les courants issus des branches du dernier étage de plusieurs circuits d'aiguillage différents, et ces informations sont utilisées pour produire des poids forts de la conversion analogique-numérique du signal Vin.

Deux mises en oeuvre principales de l'invention peuvent être prévues. Dans une première mise en oeuvre, les circuits d'aiguillage ont deux étages et permettent d'aiguiller le courant préférentiellement vers l'une des quatre branches du deuxième étage. Si l'un des circuits d'aiguillage reçoit les paires de tension se croisant pour Vin égal à Vₖ₋₁, Vₖ, Vₖ₊₁, le courant est aiguillé préférentiellement en fonction de la position relative de Vin par rapport à ces trois références. Le circuit suivant reçoit les paires de tension se croisant pour Vin = Vₖ₊₁, Vₖ₊₂, Vₖ₊₃ ; il y a au moins (n-1)/2 circuits d'aiguillage (éventuellement un de plus à une extrémité) s'il y a n références Vₖ.

Dans une autre mise en oeuvre, les circuits d'aiguillage ont trois étages, et permettent d'aiguiller le courant préférentiellement vers l'une des huit branches du troisième étage en fonction de la position de Vin par rapport à sept références de tension qui sont Vₖ₋₃, Vₖ₋₂, Vₖ₋₁, Vₖ, Vₖ₊₁, Vₖ₊₂, Vₖ₊₃ . Le circuit d'aiguillage reçoit sept paires de tensions de commande se croisant pour ces valeurs de référence. Le circuit voisin, s'il y en a, reçoit le groupe de tensions suivantes correspondant aux références Vₖ₊₃ et les six suivantes. On additionne les courants d'au moins trois des branches de sortie d'une part, et trois autres branches de sortie d'autre part, pour produire les deux signaux repliés complémentaires.

On pourrait généraliser à un nombre d'étages quelconque, en indiquant que le circuit de repliement de signal comprend M circuits d'aiguillage de courant à structure arborescente à Z étages alimentés par une source de courant, avec Z au moins égal à 2, chaque circuit d'aiguillage ayant 2^{Z} - 1 paires d'entrées recevant chacune une paire de tensions prise parmi les n paires, les 2^{Z} - 1 paires de tensions correspondant à 2^{Z} - 1 références Vₖ adjacentes, le courant de la source étant aiguillé préférentiellement dans une branche parmi 2^{z} branches de sortie en fonction des valeurs des tensions d'entrée, et le circuit d'aiguillage ayant une sortie directe obtenue par la réunion de 2^{z-1} -1 branches de sortie différentes et une sortie inverse obtenue par la réunion de 2^{z-1}-1 autres branches de sortie, les sorties directes des différents circuits d'aiguillage étant reliées entre elles et fournissant un premier signal replié, et les sorties inverses étant également reliées entre elles et fournissant un deuxième signal replié. Il est à noter que dans le cas où il y a au moins 3 étages dans les structures arborescentes (Z supérieur ou égal à 3), il peut n'y avoir qu'un seul circuit d'aiguillage pour faire le repliement, alors que si Z est inférieur ou égal à 2 il y a obligatoirement plusieurs circuits d'aiguillage.

Enfin, le convertisseur peut comporter un deuxième circuit de repliement de signal, utilisant des aiguillages de courant à structure arborescente, pour produire deux autres signaux repliés, variant avec Vin en quadrature de phase avec les premiers. Ceci peut être utile lorsque les signaux repliés sont utilisés pour une conversion analogique-numérique fine à l'aide d'un circuit d'interpolation à plusieurs étages en cascade : le premier étage reçoit alors quatre signaux repliés, dont deux sont complémentaires et les deux autres sont en quadrature de phase avec les premiers.

Dans ce cas, les circuits d'aiguillage du deuxième circuit de repliement reçoivent des paires de tensions d'entrée qui proviennent non pas des deux sorties complémentaires d'un même amplificateur, comme cela se passerait pour les aiguillages du premier circuit de repliement, mais de deux sorties d'amplificateurs différents (adjacents). Ces paires de tension se croisent alors non pas pour les références Vₖ mais pour des références situées au milieu des intervalles entre les références Vₖ. Cela suppose cependant que les références Vₖ sont suffisamment proches les unes des autres pour que les courbes de variation en fonction de Vin se croisent encore dans leur zone de variation linéaire.

Pour la réalisation pratique des circuits d'aiguillage à structure arborescente, on devra tenir compte du fait que les aiguillages sont constitués par des transistors et que ces transistors introduisent une chute de tension de mode commun d'un étage de rang plus élevé à un étage de rang moins élevé. Il sera alors préférable que les n paires de tension de commande des aiguillages aient une tension de mode commun ajustée en fonction du rang de l'étage commandé. Si une des paires de tension doit commander plusieurs aiguillages appartenant à des étages de rangs différents, on prévoira alors que cette paire de tension est dédoublée en deux paires de tension différentielles identiques mais de modes communs différents.

D'autres caractéristiques et avantages de l'invention apparaîtront à la lecture de la description détaillée qui suit et qui est faite en référence aux dessins annexés dans lesquels :
- la figure 1 représente un schéma général d'un convertisseur analogique-numérique à circuit de repliement utilisant plusieurs circuits d'aiguillage de courant;
- la figure 2 représente un diagramme de variation, en fonction de Vin, des paires de tension d'entrée du circuit de repliement;
- la figure 3 représente un diagramme de variation des tensions repliées;
- la figure 4 représente un schéma de circuit d'aiguillage à deux étages;
- la figure 5 représente l'association de plusieurs circuits d'aiguillage permettant l'élaboration des signaux repliés et des bits de poids fort de la conversion analogique-numérique;
- la figure 6 représente les courants dans certaines branches de circuits d'aiguillage dont les sorties sont connectées ensemble;
- la figure 7 représente les additions de courant dans les résistances R2 et R2b de la figure 5, permettant l'élaboration du bit B2 de la conversion analogique-numérique;
- la figure 8 représente un deuxième circuit de repliement, produisant deux autres tensions repliées, en quadrature de phase avec les premières;
- la figure 9 représente un circuit d'aiguillage à structure arborescente à trois étages produisant deux tensions repliées.

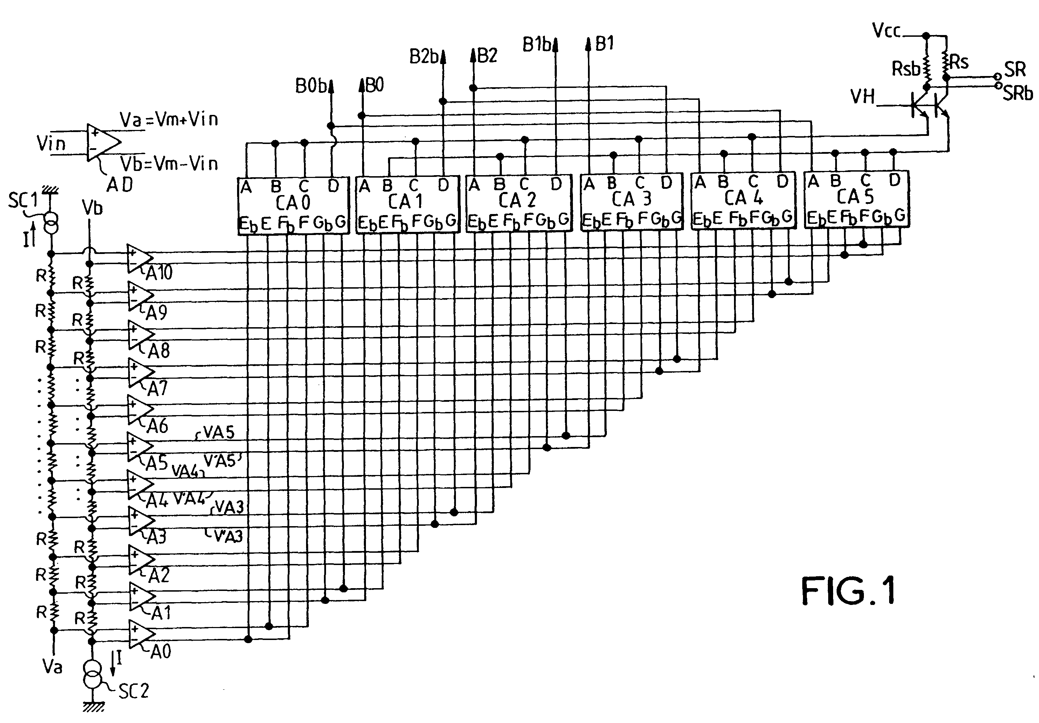

Le convertisseur de la figure 1 comporte une circuiterie non représentée pour échantillonner et bloquer la tension à convertir; on considérera donc ci-après que la tension d'entrée à convertir est une tension échantillonnée et bloquée Vin.

Le convertisseur comporte une circuiterie pour produire, à partir de cette tension Vin, n paires de tensions qui sont variables en fonction de Vin et qui sont différentes les unes des autres. Les deux tensions d'une même paire (de rang k) varient symétriquement et se croisent lorsque Vin a une valeur de référence Vₖ. Les n valeurs Vₖ sont régulièrement réparties dans la plage où Vin est susceptible de varier.

Il existe plusieurs manières de produire ces n paires de tensions. La plus simple serait de prendre n amplificateurs ayant des sorties différentielles et recevant en entrée différentielle Vin et Vₖ. L'exemple décrit sur la figure 1 utilise une autre solution avec un double pont de résistances.

La tension Vin est appliquée en entrée différentielle à un premier amplificateur différentiel AD qui fournit sur deux sorties des tensions Va = Vm+Vin et Vb = Vm-Vin, où Vm est une tension de mode commun de l'amplificateur. L'une des tensions (Va) est appliquée en tête d'un premier pont de résistances dont le pied est alimenté par une source de courant SC1 de valeur I. L'autre tension (Vb) est appliquée en tête d'un deuxième pont de résistances dont le pied est alimenté par une source de courant SC2 de même valeur I.

Les résistances en série ont des valeurs bien définies les unes par rapport aux autres, et en pratique il y a au moins n-1 résistances identiques, de valeur R, dans chaque pont.

Les tensions sur les prises du premier pont sont successivement : Va, Va-RI, Va-2RI, etc., Va-(n-1)RI.

Les tensions sur les prises du deuxième pont sont successivement : Vb, Vb-RI, Vb-2RI, etc.

On a disposé n amplificateurs différentiels A₀ à Aₙ₋₁ en aval des ponts de résistances. Le premier pont est représenté tête en bas pour simplifier la représentation des connexions entre les prises du pont et les amplificateurs.

Chaque amplificateur reçoit deux tensions d'entrée, issues l'une d'une prise intermédiaire du premier pont et l'autre d'une prise intermédiaire du deuxième pont. Par conséquent, l'une des tensions d'entrée d'un amplificateur varie comme Va-pRI, c'est-à-dire comme Vm+Vin-pRI, tandis que l'autre varie comme Vb-qRI, c'est-à-dire comme Vm-Vin-qRI. Les entiers p et q représentent les positions des prises dans chacun des ponts, en ce sens que p résistances de valeur R sont intercalées entre la tension Va et la prise du premier pont, tandis que q résistances sont intercalées entre la tension Vb et la prise du deuxième pont.

Les tensions à l'entrée de l'amplificateur connecté aux prises p et q sont donc égales pour Vin = (p-q)RI/2, et cet amplificateur fournit donc une tension différentielle nulle pour cette valeur.

I et R étant des valeurs bien définies, la valeur (p-q)RI/2 représente une tension de référence bien déterminée pouvant servir à la conversion analogique-numérique.

On peut choisir des prises intermédiaires telles que p-q soit pair : p-q= 0, p-q=2, p-q=4, p-q=6, etc., et p-q = -2, p-q= -4, p-q= -6, etc. de manière à définir n références de tension Vₖ régulièrement réparties qui sont 0, RI, 2RI, 3RI, etc. et -RI, -2RI, -3RI, etc.

Les n amplificateurs sont donc connectés à des couples de prises différents, chaque couple correspondant à une de ces tensions de référence.

Le premier amplificateur est connecté à une première prise (p=0) du premier pont et à une dernière prise (q=n-1) du deuxième pont; le deuxième est connecté à la deuxième prise (p=1) du premier pont et à l'avant dernière prise (q=n-2) du deuxième, et ainsi de suite, l'amplificateur du milieu est connecté à une prise médiane du premier pont et une prise médiane du deuxième pont, etc., jusqu'au dernier amplificateur qui est connecté à la dernière prise du premier pont et à la première prise du deuxième pont.

Dans l'exemple représenté, il y a dix résistances utiles dans le pont et onze amplificateurs A₀ à A₁₀ dont les tensions d'entrée se croisent pour Vin égal aux 11 références de tension Vₖ suivantes : -5RI, -4RI, -3RI,-2RI, -RI, 0, RI, 2RI, 3RI, 4RI, 5RI.

L' amplificateur différentiel Aₖ, de rang k dans cette série, fournit deux tensions de sortie différentielles VAₖ et V'Aₖ, variant avec Vin en opposition de phase, de manière monotone. La tension VAₖ est croissante avec Vin, la tension V'Aₖ est décroissante avec Vin. Ces deux tensions se croisent dans une zone de variation linéaire, où elles varient linéairement, et le point de croisement se situe à une valeur de Vin égale à une tension de référence Vₖ. Dans le cas où on a choisi les onze références de tension ci-dessus, réparties entre -5RI et +5RI, l'amplificateur de rang k correspond à la référence Vₖ = (k-5)RI.

On a ainsi produit n paires de tensions variant de manière monotone avec Vin, les tensions d'une paire de rang k se croisant lorsque Vin a une valeur de référence égale à Vₖ, les tensions Vₖ étant régulièrement distribuées.

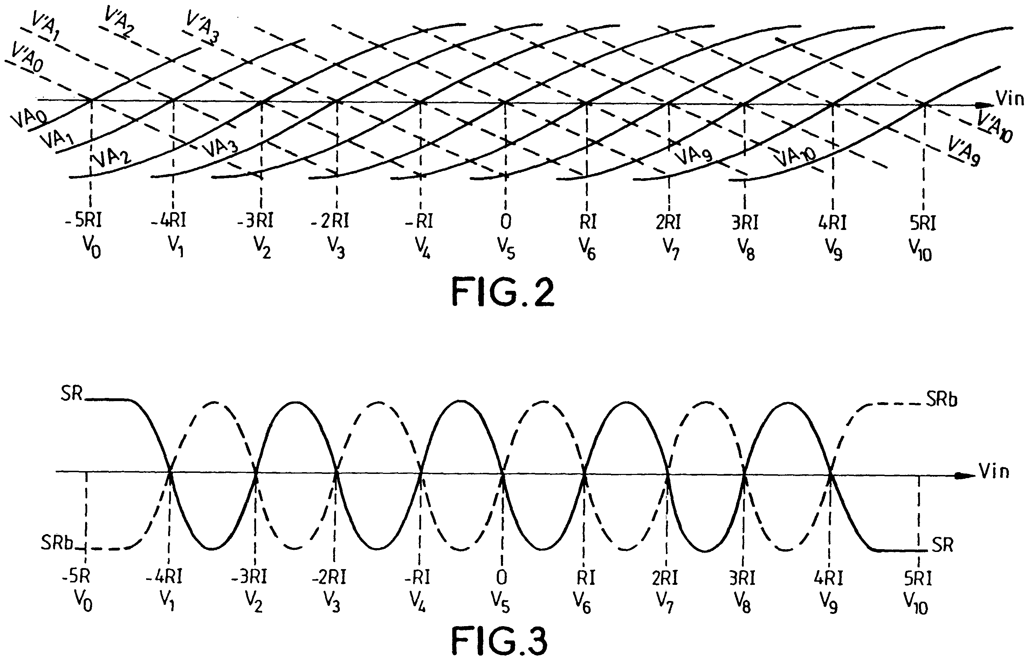

La figure 2 représente les diagrammes de variation de ces paires de tension en fonction de Vin.

En revenant à la figure 1, ces n paires de tension servent à commander un ensemble de plusieurs circuits d'aiguillage de courant, référencés CA0 à CAS, et les sorties des différents circuits d'aiguillage seront connectées ensemble pour fournir deux signaux dits repliés, c'est-à-dire des signaux variant avec Vin d'une manière périodique selon une forme sensiblement sinusoïdale, les deux signaux repliés variant avec Vin strictement en opposition de phase et se croisant à chacune des références Vₖ sauf aux extrémités V₀ et Vₙ₋₁, dans une zone de variation linéaire autour de V_{K}.

Autrement dit, l'ensemble des circuits d'aiguillage va produire une seule paire de signaux repliés SR et SRb se croisant aux différents points Vₖ, à partir de n paires de signaux monotones se croisant chacune en un seul point Vₖ.

La figure 3 représente les signaux repliés par le circuit de repliement.

Le circuit de repliement est conçu selon l'invention de manière à minimiser la consommation de courant sans réduire la précision des signaux repliés (c'est-à-dire leur position par rapport aux références Vₖ et leur linéarité de variation en fonction de Vin dans les zones de croisement).

Le circuit de repliement comporte plusieurs circuits d'aiguillage de courant qui sont des structures arborescentes qu'on décrira en détail plus loin. On peut déjà dire d'une manière générale que ce sont des structures ayant Z étages d'aiguillage de courant, Z étant au moins égal à deux, et qu'elles comportent alors 2^{Z} -1 paires de tensions d'entrée pour commander les aiguillages, et 2^{Z} branches de sortie de courant.

Sur la figure 1, on a considéré le cas le plus simple où Z = 2 et il y a donc trois paires d'entrées E, Eb; F, Fb; G, Gb, et quatre branches de sortie de courant A, B, C, D dans chaque circuit d'aiguillage.

Les sorties B et C seront considérées comme sorties principales pour la production des signaux repliés et seront appelées respectivement sortie directe et sortie inverse. Les sorties A et D sont des sorties auxiliaires.

Dans l'exemple représenté à la figure 1, il y a six circuits d'aiguillage successifs CA0 à CA5.

Un circuit d'aiguillage de rang i quelconque, à l'exception des circuits d'extrémité qui sont connectés un peu différemment pour tenir compte des effets de bord des courbes de repliement, reçoit respectivement sur ses paires d'entrées (E, Eb), (F, Fb), (G, Gb) les paires de tensions de commande issues de trois amplificateurs adjacents Aₖ₋₁, Aₖ, Aₖ₊₁. Le circuit suivant reçoit les trois paires suivantes avec cependant un recouvrement, en ce sens que le circuit suivant reçoit sur sa première paire d'entrées E, Eb la même paire de tensions (par exemple issue de Aₖ₊₁) qui est appliquée sur la dernière paire d'entrées G, Gb du circuit précédent.

Ainsi, le circuit CA1 reçoit les tensions de sortie des amplificateurs A₁, A₂, A₃. Le circuit CA2 reçoit celles de A₃, A₄, A₅, etc.

Le circuit de rang i reçoit donc sur ses entrées E et Eb respectivement la sortie VAₖ₋₁ de l'amplificateur Aₖ₋₁, sortie qui varie comme Vin et qu'on peut appeler sortie positive, et la sortie V'Aₖ₋₁ de Aₖ₋₁ qui varie comme -Vin et qu'on peut appeler sortie négative; sur ses entrées F et Fb, il reçoit respectivement la sortie positive VAₖ et la sortie négative V'Aₖ de Aₖ; et sur G et Gb il reçoit la sortie positive VAₖ₊₁ et la sortie négative V'Aₖ₊₁ de Aₖ₊₁.

Le circuit d'extrémité CA0 ne reçoit que les sorties de A₀ (sur E,Eb et F, Fb) et A₁ (sur G, Gb). Le circuit de l'autre extrémité CAS ne reçoit que celles de A₉ (sur E, Eb) et A₁₀ (sur F, Fb et G, Gb).

Les sorties principales directes B des circuits d'aiguillage CA1 à CAS sont reliées ensemble et sont reliées à une résistance de charge Rs. Cette résistance a pour rôle d'additionner les courants issus de ces sorties directes, et de convertir la somme de courants en tension. La tension produite représente alors un premier signal replié SR tel que celui de la figure 3. En pratique, on insérera un transistor en montage cascode (base à potentiel constant VH) en série entre les sorties B réunies et la résistance Rs, pour rendre la tension sur les sorties B indépendante de la somme des courants traversant la résistance Rs. Le signal replié SR est alors prélevé au point de jonction de la résistance et du collecteur du transistor.

De la même façon, les sorties inverses C des circuits d'aiguillage CA0 à CA4 sont reliées à une autre résistance de charge Rsb et fournissent le deuxième signal replié SRb, variant avec Vin en opposition de phase avec le premier.

Pour terminer le repliement aux extrémités de la gamme de variation de Vin, on utilise les deux références extrêmes V₀ et V₁₀, et on relie les sorties A et B du circuit CA0 à la résistance Rsb et les sorties C et D du circuit CA5 à la résistance Rs.

Les sorties auxiliaires A et D des différents circuits d'aiguillage sont utilisées pour recueillir des informations sur la position de Vin par rapport aux différentes références Vₖ et ainsi obtenir des bits de poids forts B0, B1, B2, d'une conversion analogique-numérique dont les bits de poids faible seront obtenus à l'aide d'un circuit d'interpolation, non représenté, à partir des signaux repliés SR et SRb.

On reviendra plus loin sur cette utilisation des sorties A et D pour les bits de poids fort, mais globalement on peut déjà indiquer ici qu'il sera nécessaire de combiner les courants des sorties auxiliaires A et D de plusieurs circuits d'aiguillage pour obtenir ces bits B0 à B1, B2.

L'architecture générale du circuit de repliement ayant ainsi été décrite en référence à la figure 1, on va maintenant décrire la constitution précise des circuits d'aiguillage.

Chaque circuit d'aiguillage a une structure arborescente pour aiguiller le courant d'une seule source de courant attachée à ce circuit, préférentiellement vers l'une ou l'autre de plusieurs branches différentielles organisées en étages successifs. Il s'agit d'une structure d'aiguillage arborescente en ce sens que chaque branche d'un étage se subdivise en deux branches d'un étage supérieur, et le courant se subdivise dans ces deux branches en fonction d'une commande d'aiguillage respective pour chaque embranchement. Cette commande d'aiguillage est effectuée par une paire de tensions d'entrée, et la répartition du courant dans les deux branches est fonction de la différence entre ces tensions d'entrée. Il y a autant de paires de tensions de commande qu'il y a d'embranchements : trois pour une structure à deux étages, sept pour une structure à trois étages, 2^{Z} -1 pour Z étages.

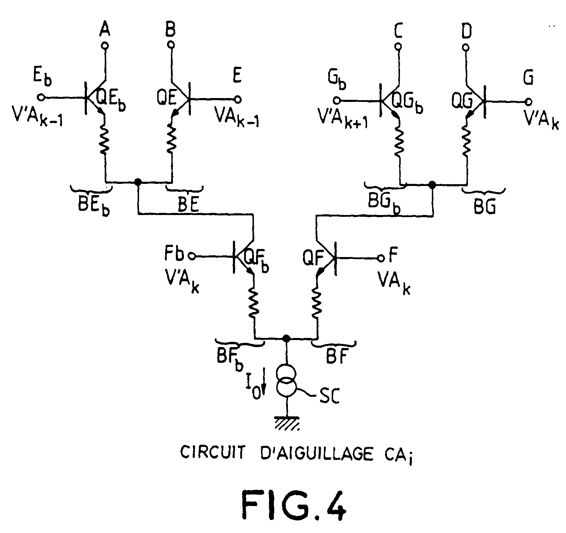

La figure 4 représente la structure d'aiguillage la plus simple selon l'invention, c'est-à-dire une structure à deux étages.

Elle comprend une source de courant SC délivrant un courant constant I₀ qui est le même pour tous les circuits d'aiguillage.

La source de courant SC alimente deux branches différentielles (premier étage d'aiguillage) dont chacune se divise elle-même en deux autres branches (deuxième étage d'aiguillage).

Les branches différentielles BF et BFb du premier étage comprennent chacune un transistor QF, QFb, relié par son émetteur à la source de courant à travers une résistance d'émetteur. Ces transistors commandent l'aiguillage unique du premier étage de la structure arborescente. Les bases de ces transistors sont les entrées Fb et F du circuit d'aiguillage et elles reçoivent les tensions V'ₖ et VAₖ de l'amplificateur Ak, tensions qui se croisent pour Vin =Vₖ. Le courant est aiguillé principalement dans la branche BF si Vin est supérieur à Vₖ et principalement dans la branche BFb si Vin est inférieur à Vₖ.

Autour de Vₖ, le partage du courant dans les deux branches varie linéairement avec Vin. Les résistances d'émetteur ont d'ailleurs seulement pour rôle d'augmenter la plage de lianéarité de variation des courants dans les branches, au voisinage du point de croisement Vₖ.

La branche BFb se subdivise en deux branches BE, BEb avec un transistor QE et un transistor QEb respectivement, contrôlés par les tensions VAₖ₋₁ et V'Aₖ₋₁. Les transistors QE et QEb constituent un premier aiguillage du deuxième étage de la structure arborescente. Ils sont connectés par leurs émetteurs à la branche BFb, c'est-à-dire au collecteur du transistor QFb. Des résistances d'émetteur peuvent également être prévues pour les transistors QE et QEb. Le courant de la branche BFb est aiguillé principalement dans la branche BEb ou dans la branche BE selon que Vin est inférieur ou supérieur à Vₖ₋₁, et le partage du courant varie linéairement avec Vin au voisinage de Vₖ₋₁.

La branche BF se subdivise elle aussi en deux branches BG et BGb comportant respectivement un transistor QG et un transistor QGb, constituant un deuxième aiguillage du deuxième étage, identique au premier aiguillage. L'aiguillage est contrôlé par la tension différentielle entre VAₖ₊₁ et V'Aₖ₊₁; le courant de la branche BF est aiguillé principalement dans la branche BGb ou dans la branche BG selon que Vin est inférieur ou supérieur à Vₖ₊₁. Le partage du courant varie linéairement au voisinage de Vₖ₊₁.

Le collecteur du transistor QE constitue la sortie en courant B du circuit (sortie directe). Le collecteur du transistor QGb constitue la sortie en courant C du circuit (sortie inverse). Ces sorties servent à l'élaboration des signaux repliés. Elles sont reliées à un potentiel positif par l'intermédiaire des résistances Rs et Rsb (figure 1) qui convertissent le courant en tension après sommation des courants de plusieurs circuits d'aiguillage.

Les collecteurs des transistors QG et QEb constituent les sorties auxiliaires A et D du circuit d'aiguillage, destinées à l'élaboration d'informations sur la position de Vin par rapport aux repliements successifs du signal.

On fera ici une remarque pratique sur la commande des transistors du circuit par des tensions différentielles VAₖ, V'Aₖ : il est souhaitable que les transistors QE, QEb, QG, QGb, du deuxième étage d'aiguillages soient alimentés par des tensions différentielles dont le mode commun est plus élevé que celui des tensions différentielles qui commandent les transistors QF, QFb du premier étage, pour tenir compte du fait qu'il y a forcément une différence de polarisation des transistors du deuxième étage par rapport à ceux du premier étage.

Les amplificateurs Aₖ₊₁ et Aₖ₋₁ devraient donc avoir des sorties dont le niveau de mode commun est décalé par rapport aux sorties de Aₖ. Mais comme d'autres circuits d'aiguillage voisins reçoivent Aₖ₊₁ ou Aₖ₋₁ sur leur premier étage d'aiguillage et non sur le deuxième, il faut en pratique prévoir que chacun des amplificateurs tels que Aₖ comporte non pas seulement deux sorties VAₖ, V'Aₖ, ayant le mode commun adapté à la commande d'un premier étage d'aiguillage, mais aussi deux autres sorties, fournissant la même tension différentielle mais avec un mode commun décalé, adaptées à la commande des transistors d'un deuxième étage d'aiguillage.

On n'a pas représenté cette particularité pour ne pas alourdir le schéma, mais on sait bien réaliser des étages de décalage de niveau en sortie des amplificateurs différentiels. Ces étages conservent les tensions différentielles en décalant leur tension de mode commun.

Pour des structures d'aiguillage à trois étages ou plus il faut aussi tenir compte de ce problème et prévoir des sorties de mode commun décalé là où c'est nécessaire.

La structure de base du circuit d'aiguillage est représentée à la figure 4 sans les éléments de circuit auxiliaires permettant d'alimenter en courant les différentes branches du circuit. On comprend cependant que le fonctionnement en circuit d'aiguillage de courant n'est possible que si les sorties A, B, C, D sont reliées à un potentiel positif susceptible de fournir le courant tiré par la source SC. En ce qui concerne les sorties B et C, on a déjà expliqué en référence à la figure 1 qu'elles sont reliées à l'alimentation Vcc par les résistances Rs et Rsb utilisées en commun par tous les circuits d'aiguillage CA0 à CA5. En ce qui concerne les sorties A et D, on pourrait les relier simplement à la tension d'alimentation Vcc, de préférence à travers un transistor monté en cascode (base commune). Dans ce cas elles n'auraient pas d'utilité en tant que sorties, et elles ne serviraient qu'à assurer un fonctionnement correct de l'aiguillage pour élaborer les signaux repliés.

On préfère cependant, comme on l'a dit, utiliser les sorties A et D pour élaborer des informations de position de Vin par rapport aux références Vₖ, ces informations constituant les poids forts de la conversion analogique-numérique dans la gamme V₀ à Vₙ₋₁.

Cette utilisation des sorties A et D nécessite dans ce cas un couplage des sorties A et D de divers circuits d'aiguillage, comme cela est d'ailleurs représenté sur la figure 1, et ce sont les sorties couplées qui seront reliées à une alimentation positive. Le couplage dépend du codage qui est utilisé dans la conversion analogique-numérique.

Avant d'entrer dans le détail de ce couplage des sorties A et D, on peut résumer en quelques mots la raison pour laquelle les circuits d'aiguillage couplés par leurs sorties B et C produisent des signaux repliés SR et SRb tels que ceux de la figure 3.

On peut prendre par exemple le circuit d'aiguillage CA2 et observer le comportement du courant de la sortie B, c'est-à-dire le courant dans la branche BE de CA2. Quand Vin est largement inférieur à V₃, le courant passe principalement dans la branche BFb, et de là va principalement dans la branche BEb. La branche BE ne laisse guère passer de courant. Puis quand Vin se rapproche de V₃, le courant de la branche BFb commence à passer sensiblement dans la branche BE et même majoritairement dans la branche BE lorsqu'on dépasse V₃ ; mais lorsque Vin se rapproche de V₄ puis dépasse V₄, le courant dans la branche BFb diminue progressivement de sorte que même si la branche BE devient privilégiée par rapport à la branche BEb, elle est de moins en moins alimentée. Enfin, lorsque Vin devient largement supérieur à V₄, la branche BE ne reçoit plus du tout de courant. Le courant dans la branche BE part donc de zéro et revient à zéro après être passé par un maximum au milieu de l'intervalle entre V3 et V4. II en est de même du courant dans la branche BE du circuit d'aiguillage suivant CA3, mais le maximum de courant se situe entre V5 et V6, de sorte que lorsque le courant dans la branche BE du circuit CA2 arrive vers zéro, le courant dans la branche BE du circuit CA3 a déjà commencé à croître. La somme des deux courants passe alors par un maximum entre V₃ et V₄, puis un minimum non nul situé entre V₄ et V₅, puis de nouveau un maximum entre V₅ et V₆ . La courbe globale de variation de la somme des courants dans plusieurs circuits d'aiguillage est une sinusoïde telle que celle de la figure 3, dont les maxima et minima sont situés au milieu des intervalles entre deux tensions Vₖ adjacentes.

On revient maintenant à la composition des sorties A et D, destinées à fournir des informations binaires sur la position de Vin par rapport aux références Vₖ. Cette composition se fonde sur des raisonnements analogues d'additions de courant dans des branches commandées par des aiguillages différents.

Dans l'exemple décrit, on préfère utiliser un code de Gray pour coder numériquement la valeur de Vin, car ce code peut être obtenu avec des couplages simples entre les différents circuits d'aiguillage.

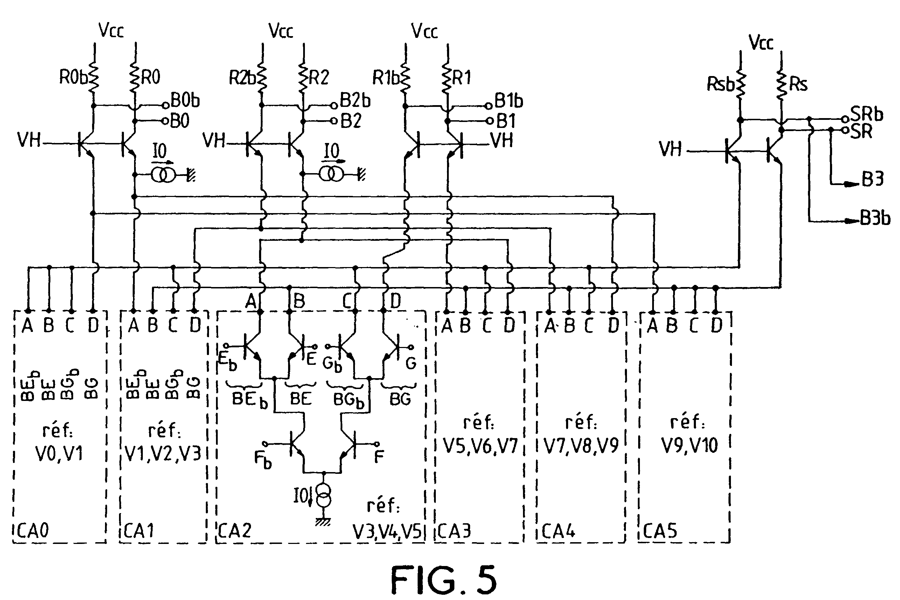

La figure 5 représente plus précisément le couplage entre les six circuits d'aiguillage, toujours dans le cas où il y a 11 références Vₖ définies par les ponts diviseurs.

Pour bien faire comprendre ce couplage, on rappelle que les poids forts B0, B1, B2 du code de Gray peuvent être obtenus de la manière suivante par rapport aux tensions de référence de la conversion :
B0 = 0 si Vin est inférieur à V₁ ou supérieur à V₉
B0 = 1 si Vin est dans la gamme utile entre V₁ et V₉

B1 = 0 si Vin est dans le bas de la gamme : Vin < V ₅
B1 = 1 si Vin est dans le haut de la gamme : Vin > V₅

B2 = 0 si Vin est inférieur à V₃ ou supérieur à V₇
B2 = 1 si Vin est compris entre V₃ et V₇

Le tableau de codage est alors le suivant :

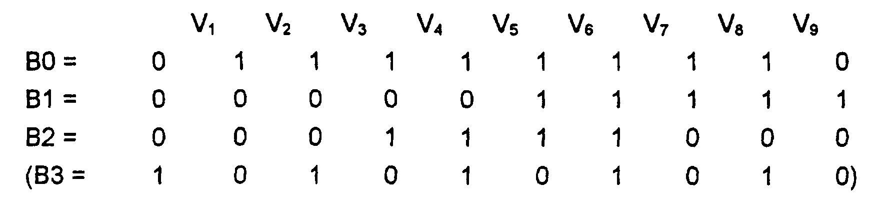

Le bit B3, définissant la position de Vin par rapport à V₂, V₄, V₆, et V₈, est défini dans ce cas en binaire pur et non en code de Gray, parce que c'est plus simple à réaliser :
B3 = 1 si Vin est compris entre V₂ et V₃, ou V₄ et V₅, ou V₆ et V₇, ou V₈ et V₉,
B3 = 0 dans le cas contraire.

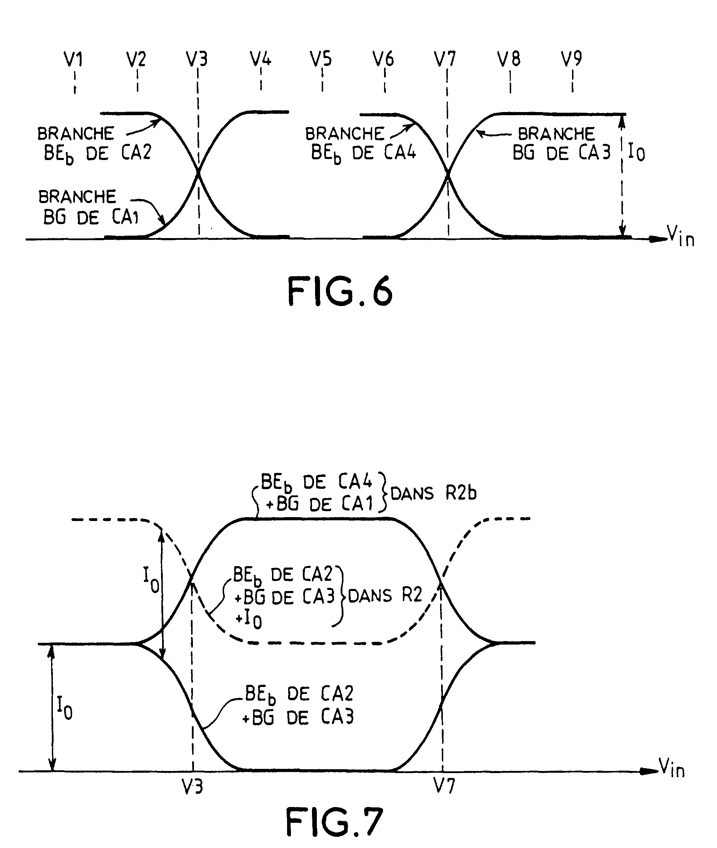

La branche BEb du circuit CA2 reçoit préférentiellement un courant si Vin est inférieur à V₃. La branche BG du circuit CA3 reçoit préférentiellement un courant si Vin est supérieur à V₇. La figure 6 représente ces courants en fonction de Vin. On réunit ces courants dans une résistance R2 en passant par un transistor en montage cascode. La figure 7 représente l'addition de ces courants (courbe inférieure sur la figure). On rajoute de plus une source de courant de valeur I₀ pour que ce courant I₀ s'ajoute aux deux précédents dans la résistance R2 (courbe pointillée sur la figure 7).

Inversement, un courant passe préférentiellement dans la branche BG de CA1 si Vin est supérieur à V₃, et un courant passe préférentiellement dans la branche BEb de CA4 si Vin est inférieur à V₇. La figure 6 représente également ces courants. On réunit ces courants dans une résistance R2b, en passant par un transistor en montage cascode. La figure 7 représente également l'addition de ces deux courants dans la résistance R2b (courbe supérieure en trait plein).

Les courbes de courant dans R2 et R2b se croisent pour Vin égal à V₃ et se croisent à nouveau pour Vin égal à V₇. La comparaison de ces courants (par comparaison des tensions aux bornes de R2 et R2b) indique sans ambiguité si Vin est située entre V₃ et V₇, ce qui donne le bit B2 et son complément B2b.

Les résistances R2 et R2b servent donc comme on le voit à la fois à effectuer une sommation de courant (qui est une fonction OU analogique) et une conversion courant-tension. Ces explications détaillées permettent de comprendre la structure complète des connexions de la figure 5.

En effet, outre les connexions qui viennent d'être décrites et qui servent à établir les bits B2 et B2b, on prévoit des connexions analogues pour établir le bit B1 et son complément B1b. Il suffit de prendre la sortie A du circuit CA3, qui fournit préférentiellement un courant si Vin est inférieur à V5 (bit B1), et la sortie D du circuit CA2, qui fournit préférentiellement un courant si Vin est supérieur à V5. La sortie A est reliée à une résistance R1 de conversion courant-tension. La sortie D est reliée à une résistance identique R1b. Le signe de la tension différentielle entre les deux résistances représente la valeur du bit B1.

Pour établir le bit B0 et son complément B0b, on relie la sortie A de CA1 (courant préférentiel si Vin < V₀) et la sortie D de CA4 (courant préférentiel si Vin > V₉) à une résistance de sommation et de conversion R0, et on relie la sortie D de CA0 à la sortie A de CA5 et à une résistance de sommation et de conversion R0b. Une source de courant de valeur I₀ rajoute un courant sur la résistance R0, comme pour la résistance R2 et pour les mêmes raisons (obtenir deux courbes de courant symétriques dans R0 et R0b qui se croisent pour V₁ et V₉).

Le dernier bit B3 des poids forts de la conversion analogique-numérique faite par le circuit de repliement peut être obtenu en comparant les signaux repliés SR et Srb puisque la différence entre ces signaux change de signe à chaque valeur Vₖ.

Des comparateurs logiques non représentés sont prévus pour fournir les bits B0 à B3 et leurs compléments sous forme logique à partir des tensions analogiques présentes aux bornes des résistances.

Les signaux repliés SR et SRb peuvent être appliqués à une structure d'interpolation à partir de laquelle on dérive des bits supplémentaires de poids faible de la conversion analogique-numérique.

Si la structure d'interpolation est une structure parallèle recevant les signaux repliés et élaborant en parallèle les comparaisons entre les signaux repliés et des références de tension, on peut se contenter des signaux SR et SRb. C'est le cas par exemple si les signaux repliés sont appliqués à un double pont diviseur du même genre que celui représenté à la figure 1, ou à un pont diviseur simple dont les prises définissent des tensions de référence connues.

Si au contraire la structure est une structure en cascade, dans laquelle on crée successivement des références de tension intermédiaires fictives pour obtenir les bits de poids de plus en plus faible, il sera en général nécessaire de disposer de deux autres signaux repliés SRQ et SRQb, dont les courbes de variation avec Vin sont en quadrature de phase avec celles des deux premiers SR et SRb. C'est le cas lorsqu'on crée, par mélange de deux paires de tensions analogiques en quadrature de phase, deux autres paires de tensions repliées, également en quadrature de phase, et ayant, outre les points de-croisement précédents, de nouveaux points de croisement situés au milieu de l'intervalle entre les points de croisement précédents.

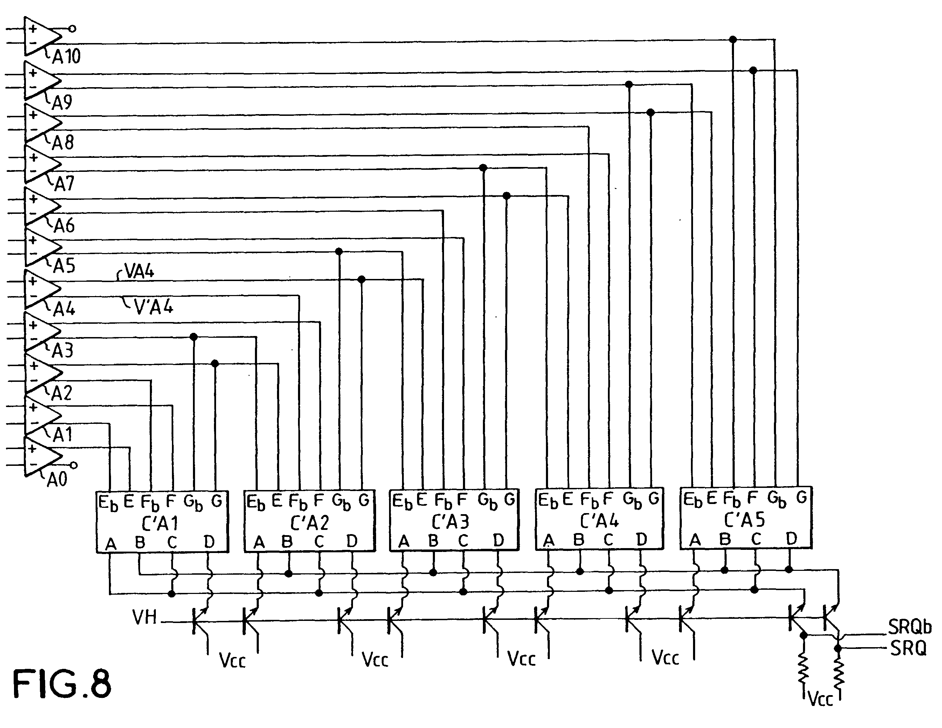

La figure 8 montre comment on peut créer les signaux repliés en quadrature de phase SRQ et SRQb à partir des sorties des mêmes amplificateurs différentiels A₀ à Aₙ₋₁, à l'aide d'autres circuits d'aiguillage de courant. Les circuits d'aiguillage CA0 à CA5 servant à élaborer les premiers signaux repliés n'ont pas été représentés sur la figure 8 pour ne pas compliquer la figure. On a représenté les cinq circuits d'aiguillage CA'1 à CA'5 , qui sont identiques aux circuits de la figure 4 et qui ont donc chacun quatre sorties A, B, C, D et trois paires d'entrées (Eb, E), (Fb, F), et (Gb, G).

Alors qu'une paire d'entrée d'un circuit d'aiguillage de la figure 1 reçoit systématiquement une paire de sorties d'un des amplificateurs A₀ à Aₙ₋₁, ici une paire d'entrées d'un circuit d'aiguillage reçoit une sortie positive d'un amplificateur, par exemple Aₖ, et une sortie négative d'un amplificateur adjacent Aₖ₊₁ ou Aₖ₋₁. Ces paires de tensions se croisent pour des références de tension V'ₖ au milieu des intervalles entre les références Vₖ, et les additions de courants obtenues en reliant toutes les sorties B et toutes les sorties C des circuits d'aiguillage permettent d'élaborer des signaux SRQ et SRQb repliés, en quadrature de phase avec SR et SRb.

Typiquement, la paire d'entrées Fb, F d'un circuit d'aiguillage de rang i reçoit respectivement la sortie négative de Aₖ et la sortie positive de Aₖ₋₁. La paire Eb, E reçoit la sortie négative de Aₖ₋₁ et la sortie positive de Aₖ₋₂. La paire Gb, G reçoit la sortie négative de Aₖ₊₁ et la sortie positive de Aₖ.

Comme à la figure 4, les sorties B sont toutes reliées ensemble (sortie directe) et reliées par l'intermédiaire d'un transistor cascode à une résistance alimentée par Vcc. Et toutes les sorties C sont reliées par l'intermédiaire d'un autre transistor cascode à une autre résistance reliée à Vcc. Les signaux repliés SRQ et SRQb sont prélevés sur les résistances.

Pour terminer le repliement du côté de V₀ et du côté de V₁₀, on prévoit que la sortie A de C'A1 est reliée à la sortie C, et que la sortie D de C'A5 est reliée à la sortie B. Si on n'a pas besoin d'élaborer d'autres informations logiques toutes les autres branches A ou D non utilisées pour le repliement peuvent être connectées à Vcc par l'intermédiaire de transistors cascode comme cela est représenté sur la figure 8. Si on a besoin d'élaborer des informations logiques supplémentaires liées à la position de Vin par rapport aux références V'ₖ, on peut le faire en reliant entre elles les sorties A et/ou D de certains circuits d'aiguillage.

Les circuits de repliement décrits en référence aux figures précédentes utilisent des circuits d'aiguillage de courant arborescents à deux étages. L'invention propose d'étendre ce concept à trois étages, voire plus.

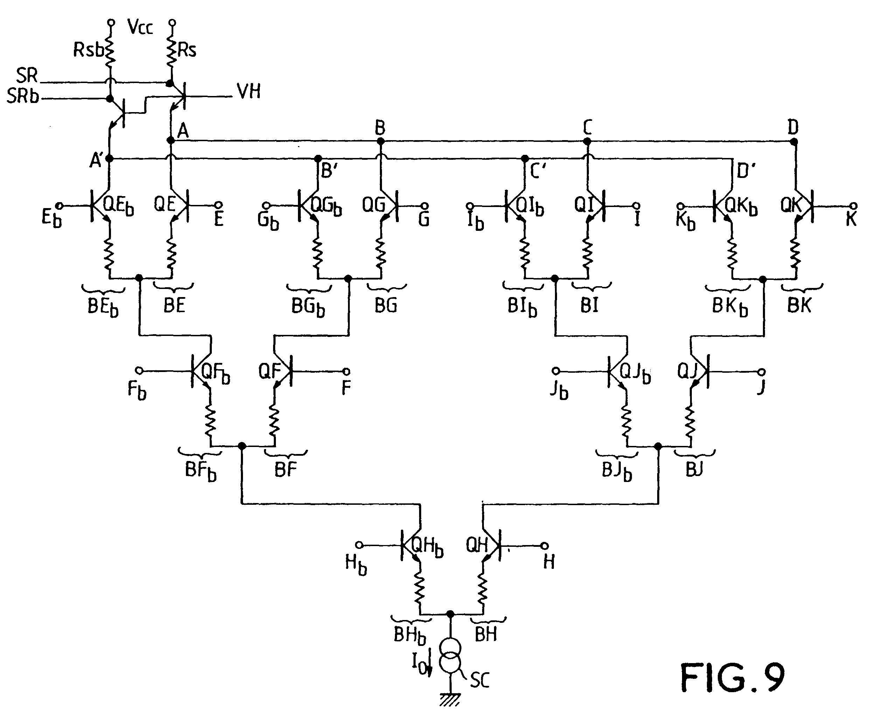

La figure 9 représente un circuit d'aiguillage à trois étages.

On peut déjà noter que l'invention est alors utilisable même avec un seul circuit d'aiguillage lorsque le nombre de tensions de référence de croisement des signaux repliés est inférieur ou égal à huit.

S'il est supérieur à huit, il faut connecter ensemble les sorties de plusieurs circuits d'aiguillage comme dans le cas des circuits d'aiguillage à deux étages.

Le premier étage d'aiguillage de la figure 9 comprend deux branches BH et BHb, comprenant respectivement le transistor QH commandé par l'entrée H et le transistor QHb commandé par l'entrée Hb. Des résistances d'émetteur peuvent être prévues. L'entrée H recevra une tension VAₖ issue d'un amplificateur différentiel Aₖ. L'entrée Hb recevra une tension complémentaire V'Aₖ. Les tensions VAₖ et V'Aₖ se croisent pour la référence Vₖ.

La branche BH se divise en deux branches BJ, BJb avec des transistors d'aiguillage QJ, QJb. La branche BHb se divise en deux branches BF, BFb, avec deux transistors d'aiguillage QF, QFb. Les quatre branches BF, BFb, BJ, BJb constituent le deuxième étage d'aiguillages, et ce deuxième étage comprend deux aiguillages. Les tensions appliquées aux entrées de commande F, Fb et J, Jb de ces deux aiguillages sont issues des amplificateurs Aₖ₋₂ et Aₖ₊₂ respectivement. Ces tensions se croisent pour les références Vₖ₋₂ et Vₖ₊₂ respectivement.

Les branches BJ, BJb, BF, BFb se subdivisent encore chacune en deux branches constituant le troisième étage d'aiguillages. Il y a quatre aiguillages dans le troisième étage. Ces quatre aiguillages, répartissant le courant entre les huit branches BK, BKb, BI, BIb, BG, BGb, BE, BEb, avec leurs transistors respectifs QK, QKb, QI, Qlb, QG, QGb, QE, QEb, sont commandés par les paires de tensions de sortie des amplificateurs Aₖ₋₃, Aₖ₋₁, Aₖ₊₁, Aₖ₊₃ respectivement. Les paires de tensions se croisent pour les références Vₖ₋₃, Vₖ₋₁, Vₖ₊₁, Vₖ₊₃.

Ces huit branches consituent les huit branches de sortie de l'aiguillage à structure arborescente. Les courants de ces branches sont recueillis sur les sorties A, B, C, D pour les branches BE, BG, BI, BK, et sur les sorties A', B', C', D', pour les branches BEb, BGb, BIb, BKb.

Le repliement de signal est effectué dans ce circuit d'aiguillage même, en réunissant les sorties A, B, C, D d'une part et les sorties A', B', C', D' d'autre part. Les courants des branches réunies s'additionnent dans deux résistances R et Rb respectivement, avec interposition d'un transistor cascode si on le souhaite. Les signaux repliés SR, SRb sont prélevés aux bornes de la résistance correspondante.

Ce circuit d'aiguillage peut être couplé à un circuit voisin recevant les sorties d'amplificateurs Aₖ₊₃ à Aₖ₊₁₀, en utilisant les principes exposés à propos des circuits d'aiguillage à deux étages : en pratique, deux circuits d'aiguillage voisins reçoivent des tensions issues d'amplificateurs différents, avec toutefois un recouvrement en ce sens que les entrées K, Kb d'un circuit d'aiguillage reçoivent les mêmes tensions que les entrées E, Eb de l'aiguillage suivant. Les sorties ABCD de l'un des circuits d'aiguillage sont reliées aux sorties ABCD de l'autre étage, à l'exception de celle des sorties qui correspond à un recouvrement. De même pour les sorties A', B', C', D'. Par exemple, s'il y a deux circuits d'aiguillage adjacents, les sorties ABC du premier circuit seront reliées aux sorties ABCD du second, et les sorties A'B'C'D' du premier circuit seront reliées aux sorties A'B'C' du second.

## Revendications

1. Convertisseur analogique-numérique **caractérisé en ce qu'**il comporte un circuit de repliement de signal comprenant :
- des moyens pour produire n paires de tensions (VAₖ, V'Aₖ) variant de manière monotone avec Vin, les tensions d'une paire de rang k se croisant lorsque Vin a une valeur de référence égale à Vₖ et variant linéairement autour de ce point de croisement, les tensions Vₖ étant régulièrement distribuées,
- au moins deux circuits d'aiguillage de courant (CA1 à CA4), dont chacun possède au moins trois paires d'entrées (E,Eb; F,Fb; G,Gb) et au moins deux sorties appelées sortie directe (B) et sortie inverse (C),
un circuit d'aiguillage de rang i ayant les caractéristiques suivantes :
- il reçoit au moins les paires de tensions de rang k-1, k, et k+1, les circuits de rang différent recevant des ensembles de paires de tensions différents,
- il comporte une source de courant (SC) alimentant un groupe de branches montées en structure arborescente à au moins deux étages dont le dernier comporte au moins quatre branches (BEb, BE, BGb, BG), chaque branche d'un étage alimentant deux branches de l'étage suivant, la répartition du courant dans chaque embranchement étant fonction des paires de tension de rang k-1, k, et k+1, et les sorties directe et inverse de ce circuit étant prises respectivement sur deux branches différentes du dernier étage,
les sorties directes (B) des différents circuits d'aiguillage étant reliées entre elles pour additionner les courants qui les parcourent et fournissant un premier signal replié (SR), et les sorties inverses (C) étant également reliées entre elles et fournissant un deuxième signal replié SRb complémentaire du premier.

2. Convertisseur selon la revendication 1, **caractérisé en ce que** les circuits d'aiguillage ont deux étages et permettent d'aiguiller le courant préférentiellement vers l'une des quatre branches du deuxième étage.

3. Convertisseur selon la revendication 2, **caractérisé en ce qu'**il comprend au moins (n-1)/2 circuits d'aiguillage pour produire les signaux repliés SR et SRb.

4. Convertisseur selon la revendication 1, **caractérisé en ce que** les circuits d'aiguillage ont trois étages et permettent d'aiguiller le courant préférentiellement vers l'une ou l'autre de huit branches du troisième étage en fonction de la position de Vin par rapport à sept références de tension qui sont Vₖ₋₃, Vₖ₋₂, Vₖ₋₁, Vₖ, Vₖ₊₁, Vₖ₊₂, Vₖ₊₃, des moyens (Rs, Rsb) étant prévus pour additionner d'une part les courants circulant dans au moins trois des branches et d'autre part les courants circulant dans au moins trois autres branches.

5. Convertisseur selon la revendication 4, **caractérisé en ce que** le circuit de repliement de signal comprend M circuits d'aiguillage de courant à structure arborescente à Z étages alimentés par une source de courant, avec Z au moins égal à 2, chaque circuit d'aiguillage ayant 2^{Z} - 1 paires d'entrées recevant chacune une paire de tensions prise parmi les n paires, les 2^{Z} - 1 paires de tensions correspondant à 2^{Z} - 1 références Vₖ adjacentes, le courant de la source étant aiguillé préférentiellement dans une branche parmi 2^{z} branches de sortie en fonction des valeurs des tensions d'entrée, et le circuit d'aiguillage ayant une sortie directe obtenue par la réunion de 2^{z-1} -1 branches de sortie différentes et une sortie inverse obtenue par la réunion de 2^{z-1}-1 autres branches de sortie, les sorties directes des différents circuits d'aiguillage étant reliées entre elles et fournissant un premier signal replié, et les sorties inverses étant également reliées entre elles et fournissant un deuxième signal replié.

6. Convertisseur selon l'une des revendications 1 à 5, **caractérisé en ce que** les circuits d'aiguillage comportent des sorties auxiliaires fournissant des courants en fonction de la position de Vin par rapport aux références Vₖ, et **en ce que** les sorties auxiliaires sont utilisées pour établir une information logique de poids fort sur la position de Vin par rapport aux références Vₖ.

7. Convertisseur selon l'une des revendications 1 à 6, **caractérisé en ce que** les circuits d'aiguillage comportent des transistors dans chaque étage d'aiguillage, ces transistors étant commandés par les sorties d'amplificateurs différentiels fournissant les paires de tension VAₖ, V'Aₖ, les amplificateurs fournissant des tensions différentielles VAₖ - V'Aₖ avec un mode commun qui dépend du rang de l'étage d'aiguillage dans la structure arborescente.

8. Convertisseur selon l'une des revendications 1 à 7, **caractérisé en ce qu'**il comporte un deuxième circuit de repliement comportant des circuits d'aiguillage de courant à structure arborescente, les circuits d'aiguillage recevant sur une paire d'entrées l'une tensions d'une paire de tensions de rang k et l'une des tensions d'une paire de rang adjacent, pour obtenir deux autres signaux repliés complémentaires variant en fonction de Vin en quadrature de phase avec les deux premiers signaux repliés.

## Patentansprüche

1. Analog/Digitalwandler, **dadurch gekennzeichnet, daß** er eine Schaltung zum Falten eines Signals enthält,
- mit Mitteln, um n Paare von Spannungen (VAₖ, V'Aₖ) zu erzeugen, die monoton mit Vin variieren, wobei die Spannungen eines Paars des Rangs k sich kreuzen, wenn Vin einen Bezugswert gleich Vₖ erreicht, und linear um diesen Kreuzungspunkt herum variieren, wobei die Spannungen Vₖ gleichmäßig verteilt sind,
- mit mindestens zwei Stromverteilorganen (CA1 bis CA4), die je mindesten drei Paare von Eingängen (E, Eb; F, Fb; G, Gb) und mindestens zwei Ausgänge, nämlich einen direkten Ausgang (B) und einen inversen Ausgang (C) besitzen,
wobei ein Stromverteilorgan des Rangs i folgende Merkmale besitzt:
- es empfängt mindestens ein Paar von Spannungen des Rangs k-1, k, k+1, wobei die Stromverteilorgane unterschiedlichen Rangs unterschiedliche Gruppen von Spannungspaaren empfangen,
- es enthält eine Stromquelle (SC), die eine Gruppe von Zweigen einer baumartigen Struktur mit mindestens zwei Stufen speist, von denen die letzte Stufe mindestens vier Zweige (BEb, BE, BGb, BG) enthält und jeder Zweig einer Stufe zwei Zweige der nächsten Stufe speist, wobei die Verteilung des Stroms bei jeder Verzweigung von den Spannungspaaren des Rangs k-1, k, und k+1 abhängt und die direkten und die inversen Ausgänge dieses Stromverteilorgans von zwei unterschiedlichen Zweigen dieser letzten Stufe abgenommen werden,
wobei die direkten Ausgänge (B) der verschiedenen Stromverteilorgane zur Addition der sie durchfließenden Ströme miteinander verbunden sind und ein erstes gefaltetes Signal (SR) liefern, während die inversen Ausgänge (C) ebenfalls miteinander verbunden sind und ein zweites gefaltetes Signal (SRb) liefern, das zum ersten komplementär ist.

2. Wandler nach Anspruch 1, **dadurch gekennzeichnet, daß** die Stromverteilorgane zwei Stufen besitzen und den Strom überwiegend in einen der vier Zweige der zweiten Stufe leiten können.

3. Wandler nach Anspruch 2, **dadurch gekennzeichnet, daß** er mindestens (n-1)/2 Stromverteilorgane zur Erzeugung der gefalteten Signale SR und SRb enthält.

4. Wandler nach Anspruch 1, **dadurch gekennzeichnet, daß** die Stromverteilorgane drei Stufen besitzen und den Strom überwiegend in einen von acht Zweigen der dritten Stufe abhängig von der Stellung von Vin bezüglich sieben Bezugsspannungen leiten, nämlich Vₖ₋₃, Vₖ₋₂, Vₖ₋₁, Vₖ, Vₖ₊₁, Vₖ₊₂, Vₖ₊₃, wobei Mittel (Rs, Rsb) vorgesehen sind, um einerseits die in mindestens drei Zweigen fließenden Ströme und andrerseits die in mindestens drei anderen Zweigen fließenden Ströme zu addieren.

5. Wandler nach Anspruch 4, **dadurch gekennzeichnet, daß** die Schaltung zum Falten des Signals M Stromverteilorgane mit baumartiger Struktur und Z Stufen enthält, die von einer Stromquelle gespeist werden, wobei Z mindestens den Wert 2 besitzt und jedes Stromverteilorgan 2^{Z}-1 Paare von Eingängen enthält, die je eines der n Spannungspaare empfangen, wobei die 2^{Z}-1 Spannungspaare 2^{Z}-1 benachbarten Bezugsspannungen Vₖ entsprechen und der Strom der Quelle überwiegend in einen der 2^{Z} Ausgangszweige abhängig von den Werten der Eingangsspannungen geleitet wird, wobei das Stromverteilorgan einen direkten Ausgang, der durch Zusammenfassung von 2^{z-1}-1 unterschiedlichen Ausgangszweigen erhalten wird, und einen inversen Ausgang besitzt, der durch die Zusammenfassung von 2^{z-1}-1 anderen Ausgangszweigen erhalten wird, und wobei die direkten Ausgänge der verschiedenen Stromverteilorgane untereinander verbunden sind und ein erstes gefaltetes Signal liefern, während die inversen Ausgänge ebenfalls untereinander verbunden sind und ein zweites gefaltetes Signal liefern.

6. Wandler nach einem der Ansprüche 1 bis 5, **dadurch gekennzeichnet, daß** die Stromverteilorgane Hilfsausgänge besitzen, die Ströme abhängig von der Lage von Vin bezüglich der Bezugsspannungen Vₖ liefern, und daß die Hilfsausgänge zur Bildung einer logischen Information höherer Wichtung für die Lage von Vin bezüglich der Bezugsspannungen Vₖ verwendet werden.

7. Wandler nach einem der Ansprüche 1 bis 6, **dadurch gekennzeichnet, daß** die Stromverteilorgane Transistoren in jeder Stufe enthalten, die von den Ausgängen von Differentialverstärkern gesteuert werden, welche Spannungspaare VAₖ, V'Aₖ liefern, wobei die Verstärker Differentialspannungen VAₖ - V'Aₖ mit einer Gleichtaktspannung liefern, die vom Rang der Stufe in der baumartigen Struktur abhängt.

8. Wandler nach einem der Ansprüche 1 bis 7, **dadurch gekennzeichnet, daß** er eine zweite Schaltung zum Falten enthält, die Stromverteilorgane mit baumartiger Struktur enthält, wobei die Stromverteilorgane an einem Paar von Eingängen eine der Spannungen eines Spannungspaars und eine der Spannungen eines Paars des benachbarten Rangs empfängt, um zwei weitere komplementäre gefaltete Signale zu erhalten, die abhängig von Vin in Phasenquadratur mit den beiden ersten gefalteten Signale variieren.

## Claims

1. Analogue/digital converter **characterized in that** it comprises a signal folding circuit comprising:
- means for producing n pairs of voltages (VAₖ, V'Aₖ) varying monotonically with Vin, the voltages of a pair of rank k crossing over when Vin has a reference value equal to Vₖ and varying linearly around this crossover point, the voltages Vₖ being regularly distributed,
- at least two current routing circuits (CA1 to CA4), each of which possesses at least three pairs of inputs (E,Eb; F,Fb; G,Gb) and at least two outputs called the direct output (B) and the inverse output (C),
a routing circuit of rank i having the following characteristics:
- it receives at least the voltage pairs of rank k-1, k and k+1, the circuits of different rank receiving different sets of voltage pairs,
- it comprises a current source (SC) supplying a group of branches arranged as a tree-like structure with at least two stages, the last of which comprises at least four branches (BEb, BE, BGb, BG), each branch of a stage supplying two branches of the next stage, the apportioning of the current in each branchoff being dependent on the voltage pairs of rank k-1, k and k+1, and the direct and inverse outputs of this circuit being tapped respectively from two different branches of the last stage,
the direct outputs (B) of the various routing circuits being linked together so as to add together the currents which flow through them and providing a first folded signal (SR), and the inverse outputs (C) also being linked together and providing a second folded signal SRb complementary to the first.

2. Converter according to Claim 1, **characterized in that** the routing circuits have two stages and make it possible to route the current preferentially to one of the four branches of the second stage.

3. Converter according to Claim 2, **characterized in that** it comprises at least (n-1)/2 routing circuits so as to produce the folded signals SR and SRb.

4. Converter according to Claim 1, **characterized in that** the routing circuits have three stages and make it possible to route the current preferentially towards one or other of eight branches of the third stage as a function of the position of Vin with respect to seven voltage references which are Vₖ₋₃, Vₖ₋₂, Vₖ₋₁, Vₖ₁, Vₖ₊₁, Vₖ₊₂, Vₖ₊₃, means (Rs, Rsb) being provided so as to add together on the one hand the currents circulating in at least three of the branches and on the other hand the currents circulating in at least three other branches.

5. Converter according to Claim 4, **characterized in that** the signal folding circuit comprises M current routing circuits with tree-like structure with Z stages supplied by a current source, with Z at least equal to 2, each routing circuit having 2^{Z}-1 pairs of inputs each receiving a voltage pair tapped off from the n pairs, the 2^{z}-1 voltage pairs corresponding to 2^{z}-1 adjacent references Vₖ, the current of the source being routed preferentially into one branch from among 2^{z} output branches as a function of the values of the input voltages, and the routing circuit having a direct output obtained by the merging of 2^{z}-1 different output branches and an inverse output obtained by the merging of 2^{z-1}-1 other output branches, the direct outputs of the various routing circuits being linked together and providing a first folded signal, and the inverse outputs also being linked together and providing a second folded signal.

6. Converter according to one of Claims 1 to 5, **characterized in that** the routing circuits comprise auxiliary outputs providing currents as a function of the position of Vin with respect to the references Vₖ, and **in that** the auxiliary outputs are used to establish a high-order logic cue relating to the position of Vin with respect to the references Vₖ.

7. Converter according to one of Claims 1 to 6, **characterized in that** the routing circuits comprise transistors in each routing stage, these transistors being controlled by the outputs of differential amplifiers providing the voltage pairs VAₖ, V'Aₖ, the amplifiers providing differential voltages VAₖ - V'Aₖ with a common mode which depends on the rank of the routing stage in the tree-like structure.

8. Converter according to one of Claims 1 to 7, **characterized in that** it comprises a second folding circuit comprising current routing circuits with tree-like structure, the routing circuits receiving on a pair of inputs one [lacuna] voltages of a pair of voltages of rank k and one of the voltages of a pair of adjacent rank, so as to obtain two other complementary folded signals varying as a function of Vin in phase quadrature with the first two folded signals.
